Europäisches Patentamt

European Patent Office

Office européen des brevets

(11) Publication number: 0 208 916
A2

# EUROPEAN PATENT APPLICATION

(21) Application number: 86108039.8

(22) Date of filing: 12.06.86

(51) Int. Cl.⁴: H 01 R 43/02

(30) Priority: 13.06.85 JP 128725/85
13.06.85 JP 128726/85

(43) Date of publication of application: 21.01.87
Bulletin 87/4

(84) Designated Contracting States: DE FR GB

(71) Applicant: Matsushita Electric Industrial Co., Ltd., 1006, Oaza Kadoma, Kadoma-shi Osaka-fu, 571 (JP)

(72) Inventor: Kitayama, Yoshifumi, 9-2-906, Higashi-Nakafuri 2-chome, Hirakata City, 573 (JP)
Inventor: Maeda, Yukio, 44-30, Himurodai 1-chome, Hirakata City, 573-01 (JP)

(74) Representative: Dr. Elisabeth Jung Dr. Jürgen Schirdewahn Dipl.-Ing. Claus Gernhardt, P.O. Box 40 14 68 Clemensstrasse 30, D-8000 München 40 (DE)

(54) Inner-lead bonding apparatus.

(57) A inner-lead bonding apparatus for bonding electrodes (54) of an IC chip (51) to inner-leads (50) disposed on a plastic film (22) has a holding means (45) for holding the inner-leads (50) and/or the plastic film (22) at a predetermined position to the IC chip (51), thereby troublesome contact between the innerleads (50) and the IC chip (51) is prevented.

## TITLE OF THE INVENTION

Inner-lead bonding apparatus

## FIELD OF THE INVENTION AND RELATED ART STATEMENT

### 1. FIELD OF THE INVENTION

The present invention relates generally to an inner-lead bonding apparatus for bonding between inner-leads and electrodes of a chip of a semiconductor device, and more particularly to an inner-lead bonding apparatus for bonding between electrodes of an IC chip and the inner-leads formed on a wound long plastic film.

### 2. DESCRIPTION OF RELATED ART

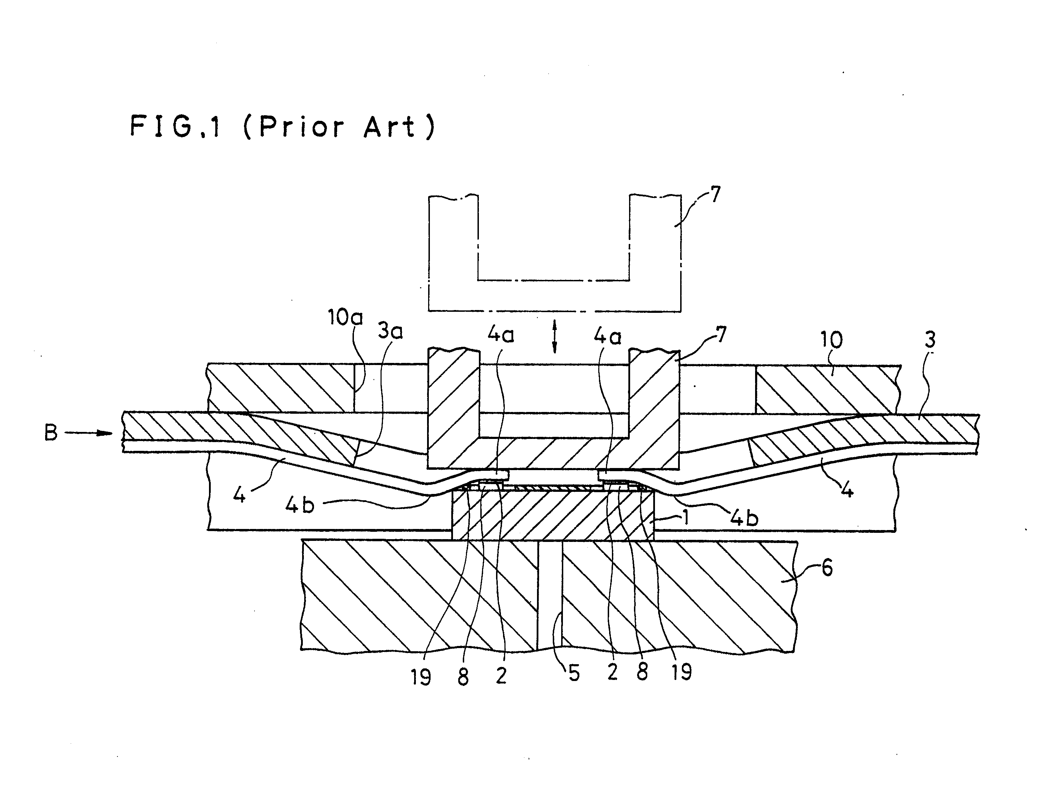

The main part of the inner-lead bonding apparatus using the wound long film in the prior art is shown in FIG.1. A film 3, for example made of polyimide, has apertures 3a at uniform intervals, and is moved by a driving means (unshown in FIG.1) to a direction shown by an arrow B. Inner-leads 4 are formed on a surface of the film 3. Bonding parts 4a of the respective inner-leads 4 project in the aperture 3a of the film 3. Gold bumps 2 are formed on surfaces of the bonding parts 4a of the respective inner-leads 4. A chip 1 of a semiconductor device, for example IC chip, has plural aluminmum electrodes to connect it to other circuits. The surfaces of the chip 1 except at the aluminum electrodes are covered by a passivation layer 19. An air suction port 5 is provided on a working table 6, and the IC chip 1

1

is set on the air suction port 5. When the film 3 is advanced by the driving means, a film guide member 10 guides the film 3. The film guide member 10 has an aperture 10a, shape of which is similar to the aperture 3a of the film 3. When the chip 1 is bonded to the inner-leads 4, the respective aluminum electrodes 8 of the chip 1 is contacted to the corresponding inner-leads 4, and they are pressed each other by a bonding tool 7 heated by heater means.

In the above-mentioned process, the bonding temperature reaches to 300°C--550°C. The heat is conducted to the film 3 through the inner-leads 4, and the film 3 is heated. Hence the film 3 is distorted and the inner-leads 4 are bent down at parts 4b adjacent to the bonding part 4a as shown in FIG.1. Consequently, shortcircuit between the inner-lead 4 and an edge part of the chip is liable to occur. Furthermore, damage of the passivation layer 19 by touch of the inner lead 4 is troublesosme problem.

SUMMARY OF THE INVENTION

An object of the present invention is to provide an inner-lead bonding apparatus wherein a shortcircuit between an inner-lead and an edge part of a chip and/or damage of a passivation layer are prevented.

The inner-lead bonding apparatus in accordance with the present invention comprises:

a movable worktable for setting a chip of semiconductor devices having electrodes thereon,

a film guide member for guiding a film with inner-leads thereon,

a bonding tool for bonding the inner-leads to the electrodes, and

holding means for holding the film at a predetermined position to the chip of the semiconductor device.

The holding means in accordance with the present invention may be suction means disposed on a film guide member, for sucking the film thereby. Hence, the distortion of the film in the bonding process is prevented.

Another holding means in accordance with the present invention is a holding member disposed on a working table, for holding the film and/or the inner leads at a predetermined height from the working table. By providing such holding means, the distortion of the film and the contact between the inner-leads and the chip of the semiconductor device are prevented.

Furthermore, the inner-lead bonding apparatus in accordance with the present invention may comprise a video camera for adjusting the position between the inner-lead and the chip of the semiconductor device and is automatically operated.

## BRIEF DESCRIPTION OF THE DRAWING

FIG.1 is the cross-sectional view of the main part of the inner-lead bonding apparatus in the prior art.

FIG.2 is a perspective view showing a configuration of an embodiment of an inner-lead bonding apparatus in accordance with the present invention.

FIG.3 is a cross-sectional view showing a bonding part of the inner-lead bonding apparatus of an embodiment in accordance with the present invention.

FIG.4 is a plan view of the bonding part of the embodiment.

FIG.5 is a cross-sectional view showing a bonding part of the inner-lead bonding apparatus of another embodiment in accordance with the present invention.

FIG.6 is a plan view of the bonding part of the other embodiment.

FIG.7 is a plan view of the bonding part of still another example of the other embodiment.

## DESCRIPTION OF THE PREFERRED EMBODIMENTS

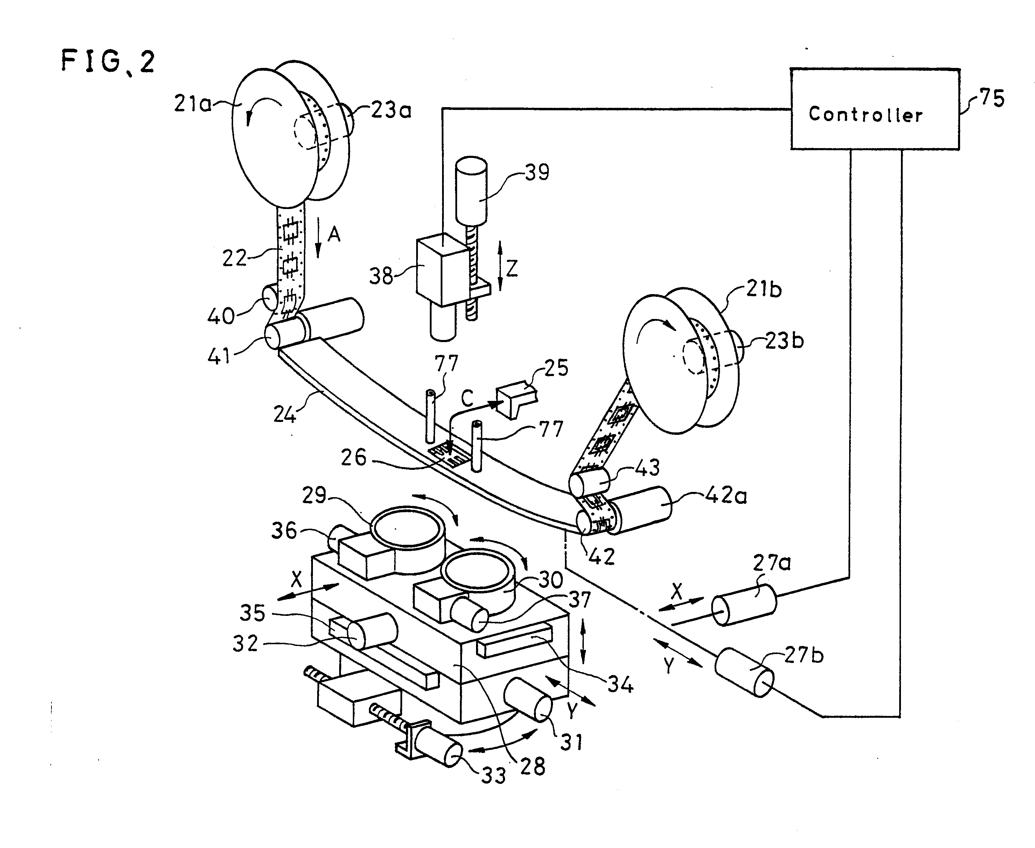

A configuration of an embodiment of an inner-lead bonding apparatus in accordance with the present invention is shown in FIG.2. A film 22, for example made of polyimide, rolled on a supply reel 21a passes through tension rollers 40 and 41, a film guide member 24, another tension roller 43 and a sprocket 42, and is wound up by a winding reel 21b which is driven by a winding motor 23b.

A winding motor 23a is disposed on the supply reel 21a, and gives a predetermined tension to the film 22. The film 22 has the same perforations as known 35 mm photographic film, and a predetermined length of the film is advanced by the sprocket 42 to a direction as shown by an arrow A. Apertures 70 are formed at predetermined positions of the film 22. Inner-leads 50 are disposed on the surface of the film 22 at adjacent parts to each aperture 70. The bonding parts 50a of the respective inner-leads 50 is exposed in the aperture 70. The film guide member 24 for guiding the film 22 has an aperture 26, which allows insertion of a bonding tool 25. The film guide member 24 can be finely moved by film guide member adjusters of known mechanism (e.g. geared down electric motors) 27a and 27b to a vertical direction X and a horizontal direction Y, respectively as shown in FIG.2. A worktable 28 has a stage 29 and a stage 30. The stage 29 is for setting a bump substrate, whereon bumps are disposed at predetermined positions, and a stage 30 is for setting an IC chip 51. The worktable 28 is moved by motors 31 and 33 to X and Y direction, respectively, and are rotated by an electric motor 33. The respective stages 29 and 30 are independently rotated by motors 36 and 37, respectively. The position of the worktable 28 is detected by linear position detectors 34 and 35.

Furthermore, the worktable 28 can be shifted up and down by lifting means (not shown in FIG.2). A video camera 38 is disposed over the worktable 28 and its position is adjusted by a motor 39. A bonding tool 25 is also disposed over the worktable 28, and is moved to up-and-down directions by a lifting means unshown in FIG.2.

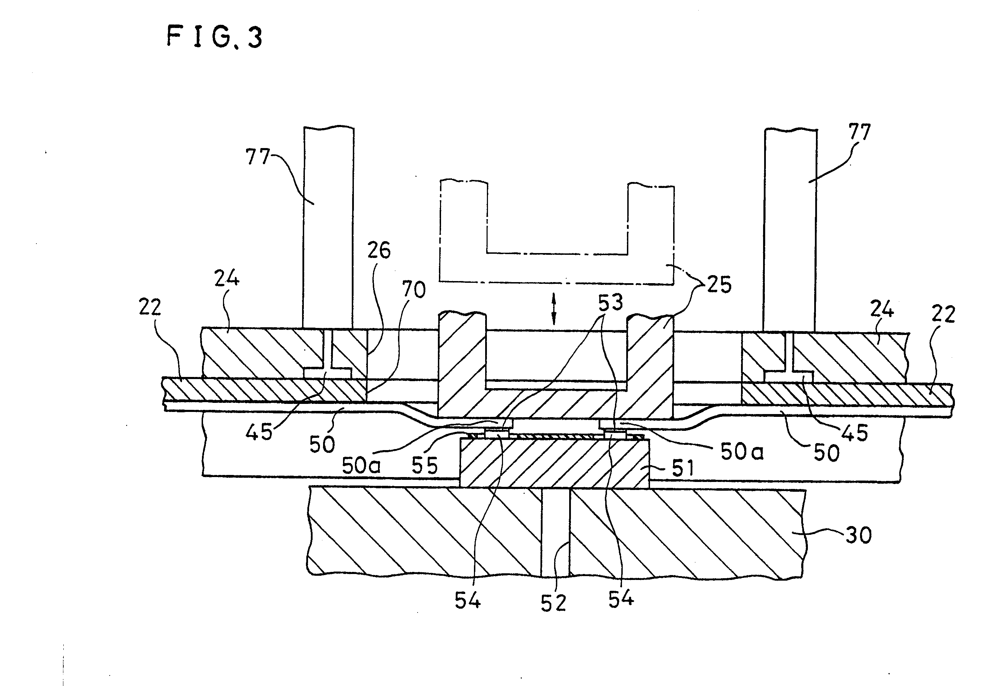

A detailed illustration of the stage 30 is shown in FIG.3. The stage 30 has an air suction port 52 which is connected to a vacuum source (not shown in FIG.1 and in FIG.3). The IC chip 51 is set on the suction port 52, and is held by the suction force.

Aluminum electrodes 54 are formed on the IC chip 51. A passivation layer 55 covers the surface of the IC chip 52 except the aluminum electrodes 54.

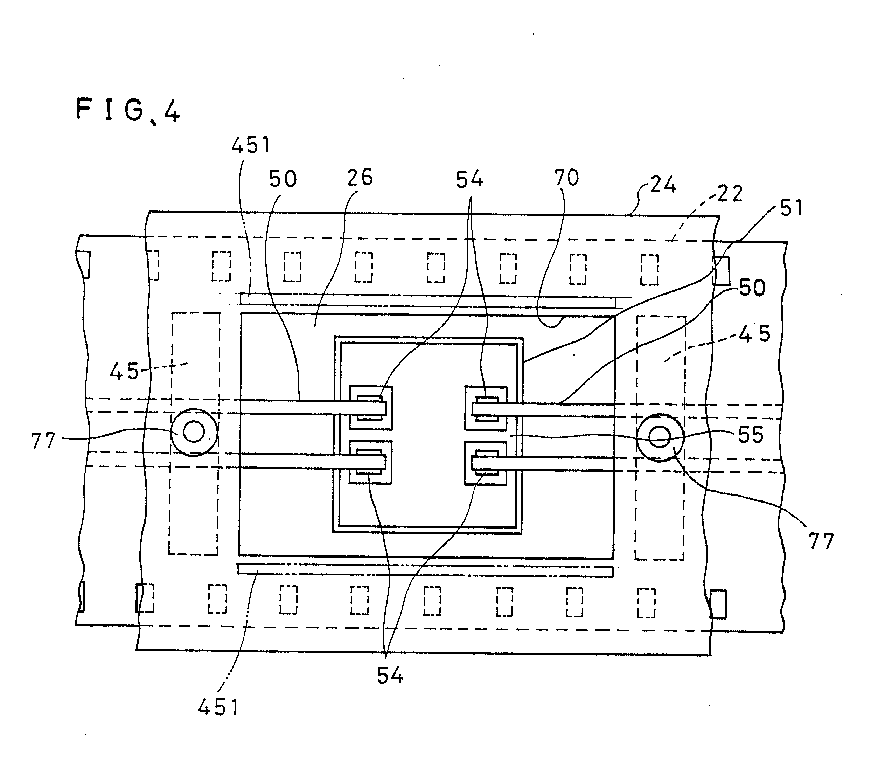

The film guide member 24 has suction ports 45, 45, which are communicated to the vacuum source through tubes 77, 77. The openings of the suction ports 45, 45 are rectangular in the embodiment as shown in FIG.4. But, it can be formed in round shape, or the like. The film 22 passes between the film guide member 24 and the stage 30 as shown in FIG.3. The bonding tool 25 waits at an elevated position out of and just over the aperture 26 of the film guide member 24 as shown by chain line in FIG.3.

The operation of the embodidment is elucidated as follows. The film 22 is advanced by the sprocket 42. The sprocket 42 stops at the position wherein the aperture 70 of the film 22 coincides to the aperture 26 of the film guide member 24, and the film 22 is sucked by the suction ports 45, 45. The stage 29 having a gold bump substrate thereon is shifted under the aperture 26 by the motor 32 which shift the worktable 28 to the Y direction, and is lifted to a position wherein the gold bump substrate touches the bonding part 50a of the inner-leads 50. Subsequently, the bonding tool 25 comes down along a path as shown by an arrow C and presses the inner-leads 50 to the gold bump substrate. The bonding tool 25 is heated during a predetermined time period, and the bumps 76 are bonded on the inner-leads 50.

After the bonding process, the worktable 28 goes down and is shifted to the Y direction. The stage 30 having an IC chip thereon is positioned under the aperture 26, and is lifted up again as shown in FIG.3. The video camera 38 detects an image of the IC chip 51 and data of its position are memorized in the memory of a controller 75. Next, the video camera detect an image of the inner-leads 50, and data of the position of the inner-leads 50 are compared with data on the IC chip 51 previously memorized in a memory in the controller 75. Thus, the film guide member adjusters 27a and 27b are controlled by the controller 75, and the film guide member 26 is moved to make coincidence between the positions of the inner-leads 50 with the position of the IC chip. Subsequently,

the bonding tool 25 comes down and presses the inner-leads to the aluminum electrodes 54 of the IC chip. The bonding tool 25 is heated and the respective inner-leads 50 are bonded on the corresponding aluminum electrodes 54. Finally the worktable 28 goes down and the film 22 is advanced.

In the above-mentioned process, since the film 22 is firmly held by the suction ports 45, 45 of the film guide member 24, it is not distorted by heat. Therefore, the inner-leads do not touch to the IC chip 51, and the damage of the passivation layer 55 is prevented.

In the embodiment shown in FIG.4, two rectangular suction ports 45, 45 are disposed on both sides of the aperture 26 perpendicuclarly to the film advancing direction. Furthermore, additional suction ports 451 which surround the aperture 26 may be provided as shown by two-dotted chain lines.

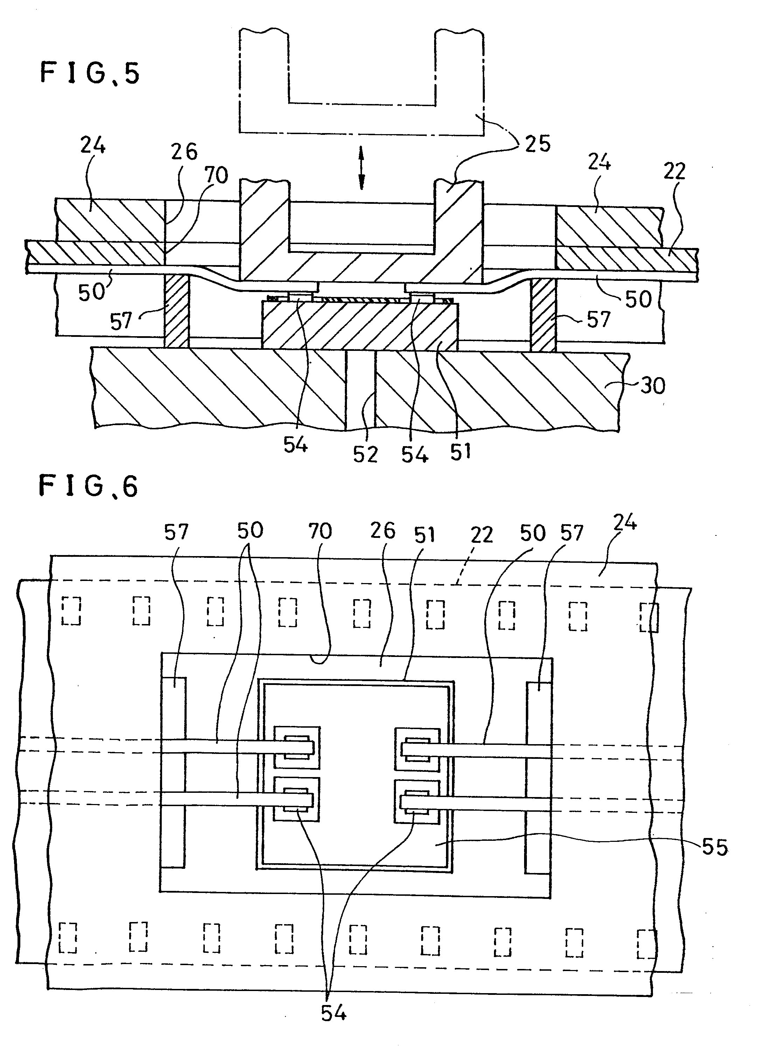

Another embodiment in accordance with the present invention is shown in FIG.5. In the embodiment, a pair of holding members 57 having a shape of a rectangular parallelepiped are disposed on the stage 30. The holding members 57 is made of stainless-steel, ceramics, glass or the like, and those are designed to have heights higher than that of the IC chip 51.

The arrangement of the holding members 57, 57 is shown in FIG.6.

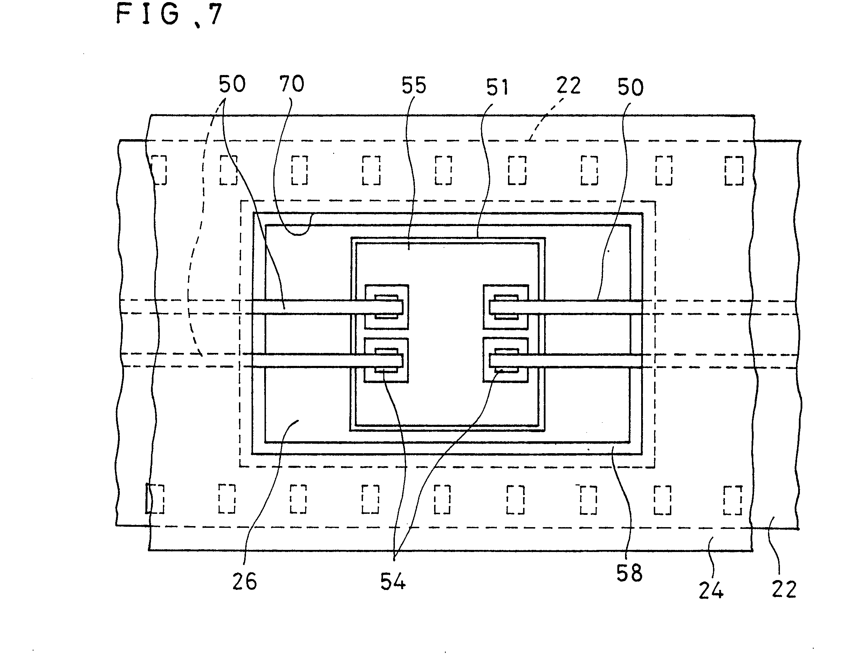

When the inner-leads 50 are bonded to the electrodes 54 of the IC chip 51, the inner-leads 50 are held by the holding members 57, 57 as shown in FIG.5. Consequently the undesirable bending of the inner-leads 50 are prevented, and both of the shortcircuit between the inner-leads 50 and the IC chip 51, and the damage of the passivation layer 55 are also prevented. Furthermore, as shown in FIG.7, a frame-shaped holding member 58 which surrounds the IC chip is useful.

WHAT IS CLAIMED IS

1.      An inner-lead bonding apparatus comprising:

        a movable worktable (28) for setting a chip (51)
of  semiconductor devices having electrodes (54) thereon,

        a film guide member (24) for guiding a film (22)
with inner-leads (50) thereon,

        a bonding tool (25) for bonding said inner-leads
(50) to said electrodes (54), and

        holding means (45) for holding said film (22) at
a predetermined position to said chip (51) of the
semiconductor devices.

2.      An inner-lead (50) bonding apparatus in
accordance with claim 1, wherein

        said holding means (45) are suction means for
sucking said film (22).

3.      An inner-lead bonding apparatus in accordance
with claim 2, wherein

        said holding means (45) comprises groove-shaped
suction ports formed on a surface of said film guide
member (24) which contact with said film and vacuum
suction means for sucking air of said suction ports.

4.      An inner-lead bonding apparatus in accordance
with claim 1, wherein

        said holding means are holding members (57)
which is formed on said worktable (28) and hold said film
(22) and/or inner-leads (50) at a predetermined height from said worktable.

5. An inner-lead bonding apparatus in accordance with claim 1, wherein

said bonding tool (25) bonds said inner-leads (50) to said electrodes (54) by pressing and heating.

6. An inner-lead bonding apparatus in accordance with claim 1, wherein

said respective inner-leads (50) have bumps (53) on bonding surfaces and said inner leads (50) are bonded to said electrodes (54) through said bumps.

7. An inner-lead bonding apparatus comprising:

a movable worktable (28) for setting a chip (51) of a semiconductor device having electrodes (50) thereon,

a film guide member (24) for guiding a film (22) with inner-leads (50) thereon,

a bonding tool (25) for bonding said inner-leads (50) to said electrodes,

holding means (45) for holding said film at a predetermined position to said chip of the semiconductor device, and

a video camera (38) for providing data for adjustment of positions of said inner-leads (50) and said chip (51) of said semiconductor device.

8. An inner-lead bonding apparatus in accordance with claim 7, wherein

said holding means are suction means (45) for

11

sucking said film.

9.       An inner-lead bonding apparatus in accordance
with claim 8, wherein

       said holding means comprises groove-shaped
suction ports (45) formed on a surface of said film guide
member (24) which contact with said film (22) and vacuum
suction means for sucking air of said suction ports.

10.       An inner-lead bonding apparatus in accordance
with claim 7, wherein

       said holding means are holding members (57)
which is formed on said worktable (28) and hold said film
(22) and/or inner-leads (50) at a predetermined height
form said worktable (28).

11.       An inner-lead bonding apparatus in accordance
with claim 7, wherein

       said bonding tool (25) bonds said inner-leads
(50) to said electrodes (54) by pressing and heating.

12.       An inner-lead bonding apparatus in accordance
with claim 7, wherein

       said respective inner-leads have bumps on
bonding surfaces and said inner-leads are bonded to said
electrodes through said bumps.

FIG.1 (Prior Art)

0208916

FIG.2

# FIG. 3

0208916

FIG.4

# FIG.5

# FIG.6

FIG.7

0208916